# EUROPÄISCHE PATENTSCHRIFT

(11) **EP 4 375 121 B1**
(45) Veröffentlichungstag und Bekanntmachung des Hinweises auf die Patenterteilung: **28.01.2026**
(21) Anmeldenummer: 23211609.5
(22) Anmeldetag: 22.11.2023
(51) Int. Cl.: B60L 53/10, B60L 53/16, B60L 53/302, B60L 53/31, H01R 13/00, H01R 13/533, H02J 7/00, H05K 7/20

(54) **FLUIDFÜHRUNGSVORRICHTUNG ZUR FÜHRUNG EINES FLUIDS IN EINER LADESTATION UND LADESTATION MIT EINER SOLCHEN FLUIDFÜHRUNGSVORRICHTUNG**
FLUID GUIDING DEVICE FOR GUIDING A FLUID IN A CHARGING STATION AND CHARGING STATION WITH SUCH A FLUID GUIDING DEVICE
DISPOSITIF DE GUIDAGE DE FLUIDE DESTINÉ À GUIDER UN FLUIDE DANS UNE STATION DE CHARGE ET STATION DE CHARGE DOTÉE D'UN TEL DISPOSITIF DE GUIDAGE DE FLUIDE

(30) Priorität: 24.11.2022 DE 102022131170
(43) Veröffentlichungstag der Anmeldung: 29.05.2024
(73) Patentinhaber: ads-tec Energy GmbH, 72622 Nürtingen (DE)
(72) Erfinder: GREIF, Andreas, 73235 Weilheim (DE); MOLCHANOV, Roman, 72654 Neckartenzlingen (DE); BAREIß, Simon, 73635 Rudersberg (DE)
(74) Vertreter: Kordel, Mattias

(56) Entgegenhaltungen:
- EP-A2- 3 403 869
- WO-A1-2022/104417
- CN-A- 114 242 328
- DE-A1- 102017 217 879
- US-A1- 2017 361 722
- US-A1- 2021 348 706
- US-A1- 2021 387 536

## Beschreibung

Die Erfindung betrifft eine Fluidführungsvorrichtung zur Führung eines Fluids in einer Ladestation und eine Ladestation mit wenigstens einem elektronischen Modul und wenigstens einer solchen Fluidführungsvorrichtung.

Fortschritte bei der Entwicklung von Batteriespeichern ermöglichen eine höhere elektrische Kapazität bei insbesondere gleichbleibendem Bauraum des Batteriespeichers. Dies führt dazu, dass in Elektrofahrzeugen Batteriespeicher mit einer höheren elektrischen Kapazität verbaut werden können. Die Nutzer von Elektrofahrzeugen erwarten üblicherweise eine rasche Ladung des Batteriespeichers, um zeitnah weiterfahren zu können und sind somit nicht unbedingt bereit, aufgrund eines eine größere elektrische Kapazität aufweisenden Batteriespeichers länger an der Ladestation zu verweilen.

Aufgrund dessen ist es notwendig, dass eine Ladeleistung zum Laden des Batteriespeichers erhöht wird. Eine Erhöhung der Ladeleistung geht insbesondere mit einer Erhöhung des Ladestroms und/oder der Ladespannung einher. Die dabei in der Ladestation insbesondere durch elektronische Module, insbesondere durch die Leistungselektronik entstehende Wärme wird üblicherweise von einer Klimatisierungsvorrichtung der Ladestation abgeführt. Dabei wird - insbesondere zur Kühlung der Leistungselektronik - üblicherweise ein durch die Klimatisierungsvorrichtung gekühltes Fluid durch eine Fluidfördervorrichtung gefördert und mittels einer Fluidführungsvorrichtung in der Ladestation verteilt. Eine solche Fluidführungsvorrichtung weist üblicherweise einen komplexen Strömungspfad auf, damit das Fluid zu allen zu kühlenden elektronischen Modulen gefördert werden kann. Aufgrund des komplexen Strömungspfads belegt eine solche Fluidführungsvorrichtung üblicherweise viel Bauraum innerhalb der Ladestation.

Das Fluid wird mittels der Fluidführungsvorrichtung üblicherweise zu einem Kühlkreislauf des elektronischen Moduls gefördert. Fällt ein solches elektronisches Modul aus, muss dessen Kühlkreislauf von der Fluidführungsvorrichtung getrennt und aus der Ladestation entnommen werden. Dabei kann es insbesondere zu einem teilweisen Auslaufen des in dem Kühlkreislauf des elektronischen Moduls enthaltenen Fluids kommen, sodass dieses ungewollt in die Ladestation gelangt und dort möglicherweise elektronische Bauteile beschädigt. Bei einem Wiedereinsetzen des Moduls in die Ladestation muss der Kühlkreislauf des elektronischen Moduls wieder strömungstechnisch und leckagefrei mit der Fluidführungsvorrichtung verbunden werden. Insbesondere aufgrund von Fertigungsungenauigkeiten oder einer ungenauen Positionierung der Anschlüsse ist es nicht immer einfach möglich, eine strömungstechnische Verbindung zwischen dem Kühlkreislauf des elektronischen Moduls unter Fluidführungsvorrichtung herzustellen.

CN 114 242 328 A offenbart eine Flüssigkeitskühlquelle zum Kühlen eines Ladesteckers und eines Ladekabels einer Ladestation. US 2021/387536 Al betrifft eine Fluidführungsvorrichtung zur Führung eines Fluids in einer Ladestation gemäß dem Stand der Technik.

Der Erfindung liegt daher die Aufgabe zugrunde, eine Fluidführungsvorrichtung zur Führung eines Fluids in einer Ladestation und eine Ladestation mit wenigstens einem elektronischen Modul und wenigstens einer solchen Fluidführungsvorrichtung zu schaffen, wobei die genannten Nachteile reduziert sind, vorzugsweise nicht auftreten.

Die Aufgabe wird gelöst, indem die vorliegende technische Lehre bereitgestellt wird, insbesondere die Lehre der unabhängigen Ansprüche sowie der in den abhängigen Ansprüchen und der Beschreibung offenbarten bevorzugten Ausführungsformen.

Die Aufgabe wird insbesondere gelöst, indem eine Fluidführungsvorrichtung zur Führung eines Fluids in einer Ladestation geschaffen wird. Die Fluidführungsvorrichtung weist einen sich in einer Längsrichtung erstreckenden Längskanal auf, wobei an dem Längskanal entlang der Längsrichtung wenigstens zwei erste quer zur Längsrichtung abgehende Fluidanschlüsse angeordnet sind. An einem ersten Ende des Längskanals ist wenigstens ein zweiter Fluidanschluss angeordnet. Der Längskanal ist an einem dem ersten Ende gegenüberliegenden zweiten Ende stirnseitig geschlossen. Der Längskanal verbindet die wenigstens zwei ersten Fluidanschlüsse strömungstechnisch parallel mit dem wenigstens einen zweiten Fluidanschluss, wobei der Längskanal verformbar ausgebildet ist, wobei der Längskanal und wenigstens ein erster Fluidanschluss, ausgewählt aus den wenigstens zwei ersten Fluidanschlüssen, eine Lagerungsausnehmung bilden, wobei die Lagerungsausnehmung eingerichtet ist, um die Fluidführungsvorrichtung in der Ladestation zu lagern. Auf diese Weise wird vorteilhaft eine besonders kompakte Fluidführungsvorrichtung, die insbesondere platzsparend in einer Ladestation angeordnet werden kann, bereitgestellt. Durch die Ausbildung der Fluidführungsvorrichtung als Längskanal ist es insbesondere möglich, das Fluid innerhalb der Fluidführungsvorrichtung in platzsparender Weise bis kurz vor ein elektronisches Modul der Ladestation zu fördern. Vorteilhaft wird dadurch auf unnötige Anschlussstellen verzichtet, womit die Gefahr einer Leckage reduziert, vorzugsweise vermieden werden kann.

Das Fluid ist insbesondere ein Klimatisierungsfluid, insbesondere eine Kühlflüssigkeit, insbesondere Wasser, insbesondere eine Wasser-Glykol-Mischung.

In einer Ausführungsform weist der sich in einer Längsrichtung erstreckende Längskanal insbesondere ein im Querschnitt rechteckiges, mit seiner längeren Seite quer zur Längsrichtung orientiertes Profil auf oder ist durch dieses gebildet. Insbesondere sind die zu der Längsrichtung parallel angeordneten Kanten - die Ecken des rechteckigen Profils - des Längskanals abgerundet.

In einer anderen Ausführungsform weist der sich in einer Längsrichtung erstreckende Längskanal insbesondere ein im Querschnitt kreisförmiges oder ellipsenförmiges Profil auf oder ist durch dieses gebildet. Ist das Profil ellipsenförmig, ist bevorzugt seine Hauptachse quer zur Längsrichtung orientiert.

Insbesondere ist der Längskanal als Lanze oder lanzenförmig ausgebildet.

Als Ladestation wird in der Elektrotechnik jedwede, insbesondere stationäre oder mobile, Vorrichtung oder elektrische Anlage bezeichnet, welche dazu dient, mobilen akkubetriebenen Geräten, Maschinen oder Kraftfahrzeugen durch einfaches Einstellen oder Einstecken Energie zuzuführen, ohne den Energiespeicher - etwa die Traktionsbatterie eines Elektroautos - zwangsläufig entnehmen zu müssen. Ladestationen für Elektroautos werden mitunter auch als "Stromtankstellen" bezeichnet und können mehrere Ladepunkte umfassen. Bekannt sind hier insbesondere Gleichstrom-Schnellladesysteme (high performance charging systems oder high power charging systems, HPC-Systeme) wie das in Europa verbreitete, sogenannte kombinierte Ladesystem (combined charging system, CCS). Beim gattungsmäßigen Gleichstromladen wird Gleichstrom aus der Ladestation direkt in die Batterie des Fahrzeugs eingespeist und hierzu durch einen leistungsstarken Gleichrichter, bevorzugt der Ladestation, vom Stromnetz oder durch große Pufferakkumulatoren an z.B. Solartankstellen bereitgestellt. Im Fahrzeug befindet sich ein Batteriemanagementsystem, das mit der Ladestation direkt oder indirekt kommuniziert, um die Stromstärke und -spannung anzupassen oder bei Erreichung einer vorbestimmten Kapazitätsgrenze den Vorgang zu beenden. Eine Leistungselektronik befindet sich hierbei üblicherweise in der Ladestation. Da die Gleichstromanschlüsse der Ladestation direkt - ohne Umweg über einen AC/DC-Wandler des Fahrzeugs - mit entsprechenden Anschlüssen der Traktionsbatterie verbunden werden, lassen sich verlustarm hohe Ladeströme übertragen, was kurze Ladezeiten ermöglicht.

In einer Ausführungsform ist die Ladestation als eine Ladesäule ausgebildet. Insbesondere weist die Ladestation mindestens einen Ladepunkt, insbesondere genau einen Ladepunkt oder genau zwei Ladepunkte, auf.

Insbesondere ist die Ladestation als Schnellladestation ausgebildet. In einer Ausführungsform ist die Ladestation als batteriegestützte Ladestation, insbesondere als batteriegestützte Schnellladestation, ausgebildet.

Gemäß der Erfindung ist vorgesehen, dass der Längskanal verformbar ausgebildet ist. Auf diese Weise können vorteilhaft Fertigungsungenauigkeiten und/oder eine ungenaue Positionierung von mit dem Längskanal korrespondierenden Anschlüssen einer Ladestation oder auch der Fluidanschlüsse selbst ausgeglichen werden. Insbesondere ist es dadurch möglich, ein elektronisches Modul besonders einfach in der Ladestation anzuordnen und eine strömungstechnische Verbindung herzustellen.

In einem anderen Beispiel ist der Längskanal starr ausgebildet. Es ist dann in besonders einfacher Weise möglich, den Längskanal - insbesondere von einer Seite oder Stirnseite her - in eine Ladestation einzuführen.

Dass der Längskanal verformbar ausgebildet ist, bedeutet im Kontext der vorliegenden technischen Lehre insbesondere, dass eine Länge des Längskanals verändert werden kann, insbesondere dass der Längskanal entlang der Längsrichtung gestaucht und/oder gedehnt werden kann. Alternativ oder zusätzlich kann der Längskanal gekrümmt werden. Insbesondere ist der Längskanal wiederholbar, insbesondere zerstörungsfrei wiederholbar, verformbar. Insbesondere ist der Längskanal verformbar, indem der Längskanal ein verformbares Material und/oder eine zur Verformung geeignete Formgebung aufweist. In einer Ausführungsform weist der Längskanal ein Wellrohr auf oder ist als Wellrohr ausgebildet.

Gemäß einer Weiterbildung der Erfindung ist vorgesehen, dass die wenigstens zwei ersten Fluidanschlüsse an dem Längskanal lösbar, insbesondere abschraubbar und/oder abziehbar, befestigt sind. Auf diese Weise ist es besonders einfach möglich, einen defekten Fluidanschluss auszutauschen oder durch einen Fluidanschluss mit einem anderen Anschlussdurchmesser zu ersetzen, insbesondere durch anschrauben oder aufstecken.

Gemäß der Erfindung ist vorgesehen, dass der Längskanal und wenigstens ein erster Fluidanschluss, ausgewählt aus den wenigstens zwei ersten Fluidanschlüssen, eine Lagerungsausnehmung, insbesondere eine Nut, bilden, wobei die Lagerungsausnehmung eingerichtet ist, um die Fluidführungsvorrichtung in der Ladestation, insbesondere wahlweise verlagerbar oder unverlagerbar relativ zu einem Gehäuse der Ladestation, zu lagern. Auf diese Weise wird vorteilhaft eine besonders kompakte Bauweise der Fluidführungsvorrichtung realisiert. Insbesondere verzichtet die Fluidführungsvorrichtung auf zusätzliche Befestigungselemente, mittels derer die Fluidführungsvorrichtung an einer Ladestation befestigt werden kann, da die Lagerungsausnehmung als Befestigungselement durch die Fluidführungsvorrichtung selbst gebildet wird.

Zur Offenbarung gehört auch eine Fluidführungsanordnung, die eine erste Fluidführungsvorrichtung mit einem starren Längskanal, und eine - insbesondere parallel zu der ersten Fluidführungsvorrichtung angeordnete -zweite Fluidführungsvorrichtung mit einem verformbare Längskanal aufweist.

Die Aufgabe wird auch gelöst, indem eine Ladestation mit wenigstens einem elektronischen Modul und wenigstens zwei erfindungsgemäßen Fluidführungsvorrichtungen oder Fluidführungsvorrichtungen nach einer oder mehreren der zuvor beschriebenen Ausführungsformen geschaffen wird. Die Ladestation weist eine erste Fluidführungsvorrichtung der wenigstens zwei Fluidführungsvorrichtungen als eine Fluidzufuhrvorrichtung auf. Die Fluidzufuhrvorrichtung weist als die wenigstens zwei ersten Fluidanschlüsse wenigstens zwei Fluidausgangsanschlüsse auf. Ein Fluidausgangsanschluss der wenigstens zwei Fluidausgangsanschlüsse ist lösbar mit einem Fluidkreislaufeingangsanschluss, insbesondere Kühlkreislaufeingangsanschluss, des wenigstens einen elektronischen Moduls, insbesondere einer Leistungselektronik, verbunden. Die Ladestation weist eine zweite Fluidführungsvorrichtung der wenigstens zwei Fluidführungsvorrichtungen als eine Fluidabfuhrvorrichtung auf. Die Fluidabfuhrvorrichtung weist als die wenigstens zwei ersten Fluidanschlüsse wenigstens zwei Fluideingangsanschlüsse auf. Ein Fluideingangsanschluss der wenigstens zwei Fluideingangsanschlüsse ist lösbar mit einem Fluidkreislaufausgangsanschluss, insbesondere Kühlkreislaufausgangsanschluss, des wenigstens einen elektronischen Moduls, insbesondere der Leistungselektronik, verbunden. Eine Fluidführungsvorrichtung, ausgewählt aus der Fluidabfuhrvorrichtung und der Fluidzufuhrvorrichtung, weist einen verformbaren Längskanal auf. In Zusammenhang mit der Ladestation ergeben sich insbesondere die Vorteile, die bereits in Zusammenhang mit der Fluidführungsvorrichtung erläutert wurden.

In einer Ausführungsform weist die andere Fluidführungsvorrichtung, ausgewählt aus der Fluidzufuhrvorrichtung und der Fluidabfuhrvorrichtung, einen starren Längskanal auf. Insbesondere weist die Ladestation eine erfindungsgemäße Fluidführungsanordnung oder eine Fluidführungsanordnung gemäß einer oder mehreren der zuvor beschriebenen Ausführungsformen auf.

Insbesondere ist ein weiterer Fluidausgangsanschluss der wenigstens zwei Fluidausgangsanschlüsse lösbar mit einem Fluidkreislaufeingangsanschluss, insbesondere Kühlkreislaufeingangsanschluss, eines weiteren elektronischen Moduls der Ladestation, insbesondere einer weiteren Leistungselektronik, verbunden.

Insbesondere ist ein weiterer Fluideingangsanschluss der wenigstens zwei Fluideingangsanschlüsse lösbar mit einem Fluidkreislaufausgangsanschluss, insbesondere Kühlkreislaufausgangsanschluss, des weiteren elektronischen Moduls, insbesondere der weiteren Leistungselektronik, verbunden.

Insbesondere durchströmt das Fluid die Fluidzufuhrvorrichtung und von dort durch den jeweiligen Fluidausgangsanschluss in den zugeordneten Fluidkreislaufeingangsanschluss, durchströmt von dort das zugeordnete elektronische Modul, um es zu kühlen, verlässt dieses wiederum durch den zugeordneten Fluidkreislaufausgangsanschluss, wobei es durch den zugeordneten Fluideingangsanschluss in die Fluidabfuhrvorrichtung eintritt und durch diese weiterströmt. Mithilfe der jeweils zwei ersten Fluidanschlüsse der Fluidführungsvorrichtungen können auf diese Weise insbesondere zwei separate elektronische Module oder alternativ auch ein größeres elektronisches Modul mit dem Fluid versorgt werden.

Gemäß einer Weiterbildung der Erfindung ist vorgesehen, dass zumindest ein Fluidanschluss, insbesondere jeder der Fluidanschlüsse, ausgewählt aus den wenigstens zwei Fluidausgangsanschlüssen und den wenigstens zwei Fluideingangsanschlüssen, eine Steckeraufnahme aufweist. Ein dem Fluidanschluss zugeordneter Fluidkreislaufanschluss, ausgewählt aus dem Fluidkreislaufeingangsanschluss und dem Fluidkreislaufausgangsanschluss, weist einen Stecker auf. Der Stecker ist mit der Steckeraufnahme strömungstechnisch verbindbar, indem der Stecker lösbar in die Steckeraufnahme eingesteckt wird. Der Stecker ist insbesondere derart ausgebildet, dass er fluiddicht geschlossen wird, wenn der Stecker von der Steckeraufnahme gelöst wird. Auf diese Weise wird vorteilhaft besonders einfach eine strömungstechnische Verbindung zwischen dem Fluidanschluss und dem Fluidkreislaufanschluss hergestellt und getrennt. Insbesondere ist es möglich, eine strömungstechnische Verbindung tropffrei zu trennen und wiederherzustellen. Somit wird insbesondere die Gefahr einer Leckage reduziert, vorzugsweise vermieden. Insbesondere wird das elektronische Modul nicht durch ein ausgelaufenes Fluid beschädigt.

Die Steckeraufnahme weist insbesondere eine Tassenform auf oder ist tassenförmig ausgebildet.

Insbesondere ist der Stecker eingerichtet, um beim Einsetzen, insbesondere beim Einstecken, insbesondere beim Eindrücken in die Steckeraufnahme eine strömungstechnische Verbindung zwischen dem Fluidanschluss und dem zugeordneten Fluidkreislaufanschluss herzustellen. Der Stecker ist derart eingerichtet, dass die strömungstechnische Verbindung beim Lösen des Steckers wieder getrennt wird.

Gemäß einer Weiterbildung der Erfindung ist vorgesehen, dass die Lagerungsausnehmung einer fixierten Fluidführungsvorrichtung, ausgewählt aus der Fluidzufuhrvorrichtung und der Fluidabfuhrvorrichtung, mit einem ersten Durchbruch einer Wandung der Ladestation zusammenwirkt, sodass ein fixierter Fluidanschluss der wenigstens zwei ersten Fluidanschlüsse der fixierten Fluidführungsvorrichtung, in der Ladestation fixiert, das heißt insbesondere verlagerungsfrei oder starr befestigt, insbesondere geklemmt, ist. Ein erster Fluidpfad ist von dem Längskanal der fixierten Fluidführungsvorrichtung zu dem fixierten Fluidanschluss gebildet, wobei der erste Fluidpfad durch den ersten Durchbruch hindurchgeführt ist. Insbesondere sind beide ersten Fluidanschlüsse der fixierten Fluidführungsvorrichtung derartig fixiert. Die Lagerungsausnehmung einer verlagerbaren Fluidführungsvorrichtung, ausgewählt aus der Fluidzufuhrvorrichtung und der Fluidabfuhrvorrichtung, wirkt mit einem zweiten Durchbruch der Wandung der Ladestation zusammen, sodass ein verlagerbarer Fluidanschluss der wenigstens zwei ersten Fluidanschlüsse der verlagerbaren Fluidführungsvorrichtung, in der Ladestation verlagerbar, insbesondere schwimmend gelagert ist. Ein zweiter Fluidpfad ist von dem Längskanal der verlagerbaren Fluidführungsvorrichtung zu dem verlagerbaren Fluidanschluss gebildet, wobei der zweite Fluidpfad durch den zweiten Durchbruch hindurchgeführt ist. Insbesondere sind beide ersten Fluidanschlüsse der verlagerbaren Fluidführungsvorrichtung derartig verlagerbar, insbesondere schwimmend gelagert. Alternativ ist einer der ersten Fluidanschlüsse der verlagerbaren Fluidführungsvorrichtung verlagerbar und der andere starr befestigt. Insbesondere wird vorteilhaft die fixierte Fluidführungsvorrichtung mittels einer Art Festlager an der Ladestation befestigt und die verlagerbare Fluidführungsvorrichtung wird mittels einer Art Loslager an der Ladestation befestigt. Insbesondere ist durch die verlagerbare Ausgestaltung der verlagerbaren Fluidführungsvorrichtung ein Ausgleich von Fertigungsungenauigkeiten und einer ungenauen Positionierung der Anschlüsse möglich.

Dass ein verlagerbarer Fluidanschluss der wenigstens zwei ersten Fluidanschlüsse der verlagerbaren Fluidführungsvorrichtung in der Ladestation verlagerbar gelagert ist, bedeutet im Kontext der vorliegenden technischen Lehre insbesondere, dass der verlagerbare Fluidanschluss in einer zu der Wandung parallel angeordneten Ebene verlagerbar, insbesondere schwimmend, gelagert ist. Insbesondere ist der verlagerbare Fluidanschluss relativ zu der Wandung der Ladestation verlagerbar. Insbesondere ist der verlagerbare Fluidanschluss relativ zu einem weiteren verlagerbaren oder fixierten Fluidanschluss der wenigstens zwei ersten Fluidanschlüsse der verlagerbaren Fluidführungsvorrichtung verlagerbar. Insbesondere ist der verlagerbare Fluidanschluss der verlagerbaren Fluidführungsvorrichtung relativ zu einem fixierten Fluidanschluss der befestigten Fluidführungsvorrichtung verlagerbar.

Gemäß einer Weiterbildung der Erfindung ist vorgesehen, dass zwischen dem verlagerbaren Fluidanschluss der verlagerbaren Fluidführungsvorrichtung und der Wandung ein Gleitelement, insbesondere ein Gleitring, insbesondere ein Kunststoffring, angeordnet ist. Auf diese Weise ist die Verlagerung der verlagerbaren Fluidführungsvorrichtung besonders einfach möglich.

Gemäß einer Weiterbildung der Erfindung ist vorgesehen, dass die Ladestation einen Elektronikbereich und einen Fluidbereich aufweist. Zwischen dem Elektronikbereich und dem Fluidbereich ist die Wandung angeordnet. Das elektronische Modul, insbesondere die Leistungselektronik, ist in dem Elektronikbereich angeordnet. Die Fluidzufuhrvorrichtung und die Fluidabfuhrvorrichtung sind in dem Fluidbereich angeordnet. Auf diese Weise kann die Ladestation besonders sicher und zuverlässig betrieben werden, da insbesondere eine räumliche Trennung zwischen dem Elektronikbereich und dem Fluidbereich realisiert ist. Insbesondere kommt es in dem Elektronikbereich nicht zu einer Kondensatbildung an der Fluidführungsvorrichtung, da diese in dem räumlich getrennten Fluidbereich angeordnet ist.

Insbesondere ist der Fluidbereich geodätisch unter dem Elektronikbereich angeordnet. Auf diese Weise kann gegebenenfalls aus dem Fluidbereich austretendes Fluid nicht in den Elektronikbereich fließen. Alternativ oder zusätzlich ist die Wandung, die den Fluidbereich von dem Elektronikbereich trennt oder abgrenzt, horizontal ausgerichtet. Insbesondere ist der Elektronikbereich oberhalb der horizontalen Wandung angeordnet, und der Fluidbereich ist unterhalb der horizontalen Wandung angeordnet.

Gemäß einer Weiterbildung der Erfindung ist vorgesehen, dass die Ladestation eine Wärmespeichervorrichtung und eine Klimatisierungsvorrichtung aufweist. Die Fluidzufuhrvorrichtung weist als den wenigstens einen zweiten Fluidanschluss zwei zweite Fluidanschlüsse, nämlich einen Wärmespeichervorrichtungseingang als einen ersten zweiten Fluidanschluss und einen Klimatisierungsvorrichtungsausgang als einen zweiten zweiten Fluidanschluss auf. Der Wärmespeichervorrichtungseingang ist strömungstechnisch mit der Wärmespeichervorrichtung verbunden, und der Klimatisierungsvorrichtungsausgang ist strömungstechnisch mit einem Zulauf der Klimatisierungsvorrichtung verbunden. Die Fluidabfuhrvorrichtung weist als den wenigstens einen zweiten Fluidanschluss zwei zweite Fluidanschlüsse, nämlich einen Wärmespeichervorrichtungsausgang als einen ersten zweiten Fluidanschluss und einen Klimatisierungsvorrichtungseingang als einen zweiten zweiten Fluidanschluss auf. Der Wärmespeichervorrichtungsausgang ist strömungstechnisch mit der Wärmespeichervorrichtung verbunden, und der Klimatisierungsvorrichtungseingang ist strömungstechnisch mit einem Ablauf der Klimatisierungsvorrichtung verbunden. Auf diese Weise wird vorteilhaft ein besonders einfacher und bauraumsparender Strömungspfad in der Ladestation realisiert. Vorteilhaft wird auf zusätzliche Leitungen und Ventile verzichtet.

Die Wärmespeichervorrichtung ist insbesondere ein Behälter oder ein Tank für das Fluid. Insbesondere ist die Wärmespeichervorrichtung isoliert, insbesondere thermisch isoliert.

Gemäß einer Weiterbildung der Erfindung ist vorgesehen, dass die zwei Fluidausgangsanschlüsse und der Klimatisierungsvorrichtungsausgang derart aufeinander abgestimmt sind, dass im Betrieb der Ladestation eine vorbestimmte Aufteilung der jeweils hindurchtretenden Fluidströme erreicht ist, was auch als hydraulischer Abgleich bezeichnet wird. Auf diese Weise kann vorteilhaft auf Zusatzbauteile zur Durchführung des hydraulischen Abgleichs verzichtet werden. Ferner kann auch auf ein zusätzliches Abgleichsmodul zur Durchführung des hydraulischen Abgleichs verzichtet werden.

Alternativ oder zusätzlich ist vorgesehen, dass die zwei Fluideingangsanschlüsse und der Klimatisierungsvorrichtungseingang derart aufeinander abgestimmt sind, dass im Betrieb der Ladestation eine vorbestimmte Aufteilung der jeweils durch die beiden Fluidausgangsanschlüsse und den Klimatisierungsvorrichtungsausgang hindurchtretenden Fluidströme erreicht ist.

Gemäß einer Weiterbildung der Erfindung ist vorgesehen, dass die Ladestation eine Fluidfördervorrichtung aufweist. Die Fluidfördervorrichtung ist eingerichtet, um ein Fluid der Ladestation zu fördern. Dadurch wird insbesondere sichergestellt, dass ausreichend viel Fluid durch die Fluidführungsvorrichtung gefördert wird.

Insbesondere fördert die Fluidfördervorrichtung ein Fluid aus der Wärmespeichervorrichtung über den Wärmespeichervorrichtungseingang in die Fluidzufuhrvorrichtung. Insbesondere trennt sich hier die Strömung in drei Fluidströmungsanteile:
Ein erster Fluidströmungsanteil strömt insbesondere über den Klimatisierungsvorrichtungsausgang sowie über den Zulauf der Klimatisierungsvorrichtung in die Klimatisierungsvorrichtung und wird dort gekühlt. Insbesondere strömt der gekühlte erste Fluidströmungsanteil über den Ablauf der Klimatisierungsvorrichtung und den Klimatisierungsvorrichtungseingang in die Fluidabfuhrvorrichtung.

Ein zweiter Fluidströmungsanteil strömt insbesondere von der Fluidzufuhrvorrichtung über einen der Fluidausgangsanschlüsse und den zugeordneten Fluidkreislaufeingangsanschluss des zugeordneten elektronischen Moduls in einen Fluidkreislauf des elektronischen Moduls. Insbesondere nimmt der zweite Fluidströmungsanteil Wärme von dem elektronischen Modul auf. Insbesondere strömt der erwärmte zweite Fluidströmungsanteil über den Fluidkreislaufausgangsanschluss des elektronischen Moduls und über einen der Fluideingangsanschlüsse der Fluidabfuhrvorrichtung in die Fluidabfuhrvorrichtung.

Ein dritter Fluidströmungsanteil strömt insbesondere von der Fluidzufuhrvorrichtung über den anderen Fluidausgangsanschluss und den zugeordneten Fluidkreislaufeingangsanschluss des zugeordneten elektronischen Moduls in einen Fluidkreislauf des elektronischen Moduls. Insbesondere nimmt der dritte Fluidströmungsanteil Wärme von dem elektronischen Modul auf. Insbesondere strömt der erwärmte dritte Fluidströmungsanteil über den Fluidkreislaufausgangsanschluss des elektronischen Moduls und über den anderen Fluideingangsanschluss der Fluidabfuhrvorrichtung in die Fluidabfuhrvorrichtung.

Der zuvor beschriebene hydraulische Abgleich umfasst insbesondere eine vorbestimmte Aufteilung zwischen dem ersten, dem zweiten und dem dritten Fluidströmungsanteil.

Insbesondere vereinigt sich in der Fluidabfuhrvorrichtung der erste Fluidströmungsanteil mit dem zweiten und dritten Fluidströmungsanteil, und der vereinigte Fluidstrom strömt über den Wärmespeichervorrichtungsausgang zurück in die Wärmespeichervorrichtung.

Die Erfindung wird im Folgenden anhand der Zeichnung näher erläutert. Dabei zeigen:
- Fig. 1: eine schematische Darstellung eines Ausführungsbeispiels einer Fluidführungsanordnung mit zwei Fluidführungsvorrichtungen zur Führung eines Fluids einer Ladestation;
- Fig. 2: eine schematische Darstellung eines Ausführungsbeispiels eines ersten Fluidanschlusses 7 der Fluidführungsvorrichtungen gemäß Figur 1 als eine Steckeraufnahme;
- Fig. 3: eine schematische, ausschnittsweise Darstellung einer Schnittansicht eines Längsschnitts von einer der Fluidführungsvorrichtungen gemäß Figur 1;
- Fig. 4a: eine schematische Darstellung einer ersten Ansicht eines Ausführungsbeispiels einer Ladestation mit einer Fluidführungsanordnung gemäß Figur 1;
- Fig. 4b: eine schematische Darstellung einer zweiten Ansicht des Ausführungsbeispiels der Ladestation gemäß Figur 4a;
- Fig. 5a: eine schematische, vergrößerte Darstellung einer Schnittansicht eines ersten Schnitts der Ladestation gemäß Figur 4b, und
- Fig. 5b: eine schematische, vergrößerte Darstellung einer Schnittansicht eines zweiten Schnitts der Ladestation gemäß Figur 5a.

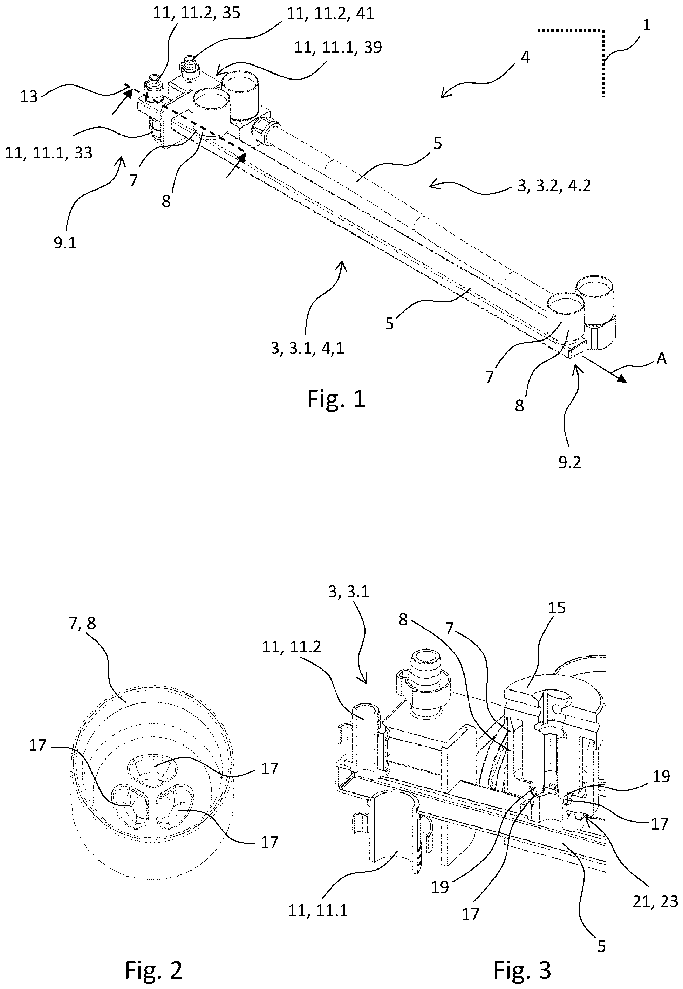

**Figur 1** zeigt eine schematische Darstellung eines Ausführungsbeispiels einer Fluidführungsanordnung 4 mit Ausführungsbeispielen von Fluidführungsvorrichtungen 3 zur Führung eines Fluids einer Ladestation 1.

In diesem Ausführungsbeispiel sind zwei Fluidführungsvorrichtungen 3, nämlich eine erste Fluidführungsvorrichtung 3.1 und eine zweite Fluidführungsvorrichtung 3.2 vorgesehen.

Die Fluidführungsvorrichtungen 3 weisen jeweils einen sich in einer durch dein Pfeil A dargestellten Längsrichtung erstreckenden Längskanal 5 auf, wobei an dem Längskanal 5 entlang der Längsrichtung wenigstens zwei erste quer zur Längsrichtung abgehende Fluidanschlüsse 7 angeordnet sind. An einem ersten Ende 9.1 des Längskanals 5 ist wenigstens ein zweiter Fluidanschluss 11, hier zwei zweite Fluidanschlüsse 11 angeordnet. Der Längskanal 5 ist an einem dem ersten Ende 9.1 gegenüberliegenden zweiten Ende 9.2 stirnseitig geschlossen. Der Längskanal 5 verbindet die wenigstens zwei ersten Fluidanschlüsse 7 strömungstechnisch parallel mit dem wenigstens einen zweiten Fluidanschluss 11.

Es ist - hier nur bei der zweiten Fluidführungsvorrichtung 3.2 - vorgesehen, dass der Längskanal 5 verformbar ausgebildet ist. Bei der ersten Fluidführungsvorrichtung 3.1 ist der Längskanal 5 starr ausgebildet.

Bevorzugt ist vorgesehen, dass die wenigstens zwei ersten Fluidanschlüsse 7 an dem Längskanal 5 lösbar, bevorzugt abschraubbar und/oder abziehbar, befestigt sind.

Bevorzugt ist der Längskanal 5 als Lanze oder lanzenförmig ausgebildet.

Bevorzugt sind die zwei ersten Fluidanschlüsse 7 jeweils als Steckeraufnahme 8 ausgebildet. Eine solche Steckeraufnahme 8 ist in Figur 2 gezeigt.

Ein strichliert dargestellter Längsschnitt 13 der ersten Fluidführungsvorrichtung 3.1 ist in Figur 3 erläutert.

**Figur 2** zeigt eine schematische Darstellung eines Ausführungsbeispiels eines als Steckeraufnahme 8 ausgebildeten ersten Fluidanschlusses 7 der Fluidführungsvorrichtungen 3 gemäß Figur 1.

Dabei sind gleiche und funktionsgleiche Elemente in allen Figuren mit gleichen Bezugszeichen versehen, sodass insoweit jeweils auf die vorangegangene Beschreibung verwiesen wird.

Die Steckeraufnahme 8 ist bevorzugt durch Einschrauben derselben in den Längskanal 5 mit dem Längskanal 5 verbindbar. Das Einschrauben erfolgt bevorzugt mittels eines in Figur 3 dargestellten Steckschlüssels 15. Die Steckeraufnahme 8 weist bevorzugt drei insbesondere nierenförmig ausgebildete Ausnehmungen 17 auf, in die der Steckschlüssel 15, der drei mit den Ausnehmungen 17 korrespondierende, insbesondere nierenförmige Erhöhungen 19 aufweist, eingreift.

**Figur 3** zeigt eine schematische, ausschnittsweise Darstellung einer Schnittansicht des Längsschnitts 13 der ersten Fluidführungsvorrichtung 3.1 gemäß Figur 1. Die Darstellung und die Erläuterungen treffen aber genauso auch auf die zweite Fluidführungsvorrichtung 3.2 zu. Der Steckschlüssel 15 mit den insbesondere nierenförmigen Erhöhungen 19 greift hier in die insbesondere nierenförmigen Ausnehmungen 17 der Steckeraufnahme 8 ein.

Es ist vorgesehen, dass der Längskanal 5 und wenigstens ein erster Fluidanschluss 7 eine Lagerungsausnehmung 21, bevorzugt eine Nut 23, bilden, wobei die Lagerungsausnehmung 21 eingerichtet ist, um die Fluidführungsvorrichtung 3 in einer Ladestation 1, bevorzugt wahlweise verlagerbar oder unverlagerbar relativ zu einem Gehäuse der Ladestation 1, zu lagern.

Zu erkennen sind ebenfalls die zwei zweiten Fluidanschlüsse 11 der ersten Fluidführungsvorrichtung 3.1, nämlich ein erster zweiter Fluidanschluss 11.1 und ein zweiter zweiter Fluidanschluss 11.2.

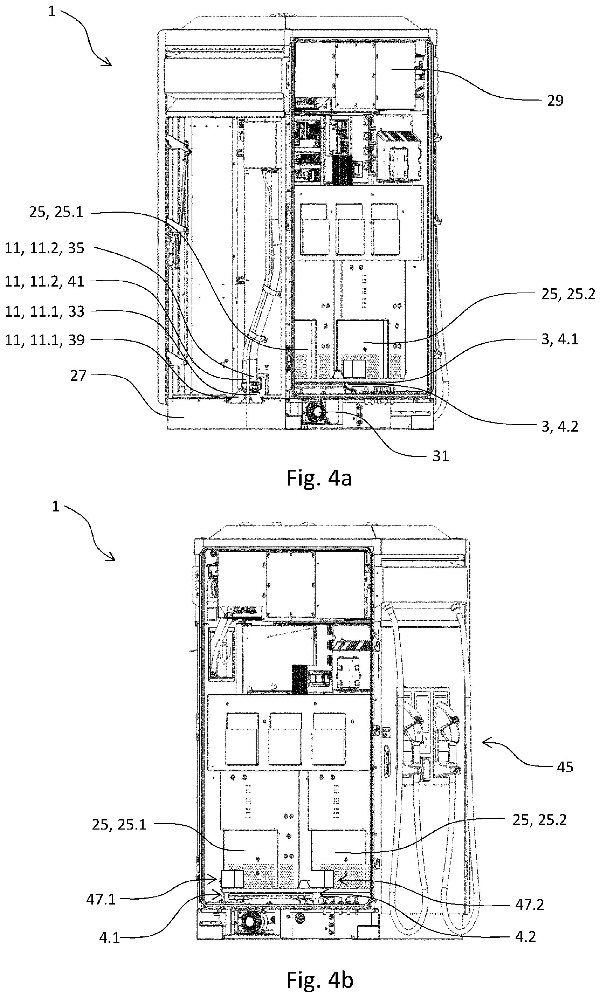

**Figur 4a** zeigt eine schematische Darstellung einer ersten Ansicht eines Ausführungsbeispiels einer Ladestation 1, mit der Fluidführungsanordnung 4 gemäß Figur 1.

Die Ladestation 1 weist ferner wenigstens ein elektronisches Modul 25, nämlich ein erstes elektronisches Modul 25.1 und ein zweites elektronisches Modul 25.2, sowie eine Wärmespeichervorrichtung 27 und eine Klimatisierungsvorrichtung 29 auf. Ferner weist die Ladestation 1 eine Fluidfördervorrichtung 31 auf, die eingerichtet ist um ein Fluid der Ladestation 1 zu fördern.

Die Ladestation 1 weist eine Fluidführungsvorrichtung 3 der wenigstens zwei Fluidführungsvorrichtungen 3 als eine Fluidzufuhrvorrichtung 4.1 und die andere Fluidführungsvorrichtung 3 der wenigstens zwei Fluidführungsvorrichtungen 3 als eine Fluidabfuhrvorrichtung 4.2 auf. Die Fluidabfuhrvorrichtung 4.2 ist quer zur Bildebene hinter der Fluidzufuhrvorrichtung 4.1 angeordnet, also einem Betrachter abgewandt. Dementsprechend ist die Fluidzufuhrvorrichtung 4.1 quer zur Bildebene vor der Fluidabfuhrvorrichtung 4.2 angeordnet, also einem Betrachter zugewandt.

Die Fluidzufuhrvorrichtung 4.1 weist - insbesondere auch mit Bezug auf Figur 1 - als den wenigstens einen zweiten Fluidanschluss 11 zwei zweite Fluidanschlüsse 11, nämlich einen Wärmespeichervorrichtungseingang 33 als den ersten zweiten Fluidanschluss 11.1 und einen Klimatisierungsvorrichtungsausgang 35 als den zweiten zweiten Fluidanschluss 11.2 auf. Der Wärmespeichervorrichtungseingang 33 ist strömungstechnisch mit der Wärmespeichervorrichtung 27 verbunden und der Klimatisierungsvorrichtungsausgang 35 ist strömungstechnisch mit einem Zulauf der Klimatisierungsvorrichtung 29 verbunden. Die Fluidabfuhrvorrichtung 4.2 weist als den wenigstens einen zweiten Fluidanschluss 11 zwei zweite Fluidanschlüsse 11, nämlich einen in Figur 1 verdeckten Wärmespeichervorrichtungsausgang 39 als den ersten zweiten Fluidanschluss 11.1 und einen Klimatisierungsvorrichtungseingang 41 als den zweiten zweiten Fluidanschluss 11.2 auf. Der Wärmespeichervorrichtungsausgang 39 ist strömungstechnisch mit der Wärmespeichervorrichtung 27 verbunden und der Klimatisierungsvorrichtungseingang 41 ist strömungstechnisch mit einem Ablauf der Klimatisierungsvorrichtung 29 verbunden.

**Figur 4b** zeigt eine schematische Darstellung einer zweiten Ansicht des Ausführungsbeispiels der Ladestation 1 gemäß Figur 4a.

Die Ladestation 1 weist zwei Ladepunkte mit jeweils einem Ladestecker 45 zum Laden eines Batteriespeichers eines nicht dargestellten Elektrofahrzeugs auf.

Das erste elektronische Modul 25.1 ist an einer ersten Stelle 47.1 mit der Fluidzufuhrvorrichtung 4.1 und der Fluidabfuhrvorrichtung 4.2 verbunden.

Das zweite elektronische Modul 25.2 ist an einer zweiten Stelle 47.2 mit der Fluidzufuhrvorrichtung 4.1 und der Fluidabfuhrvorrichtung 4.2 verbunden.

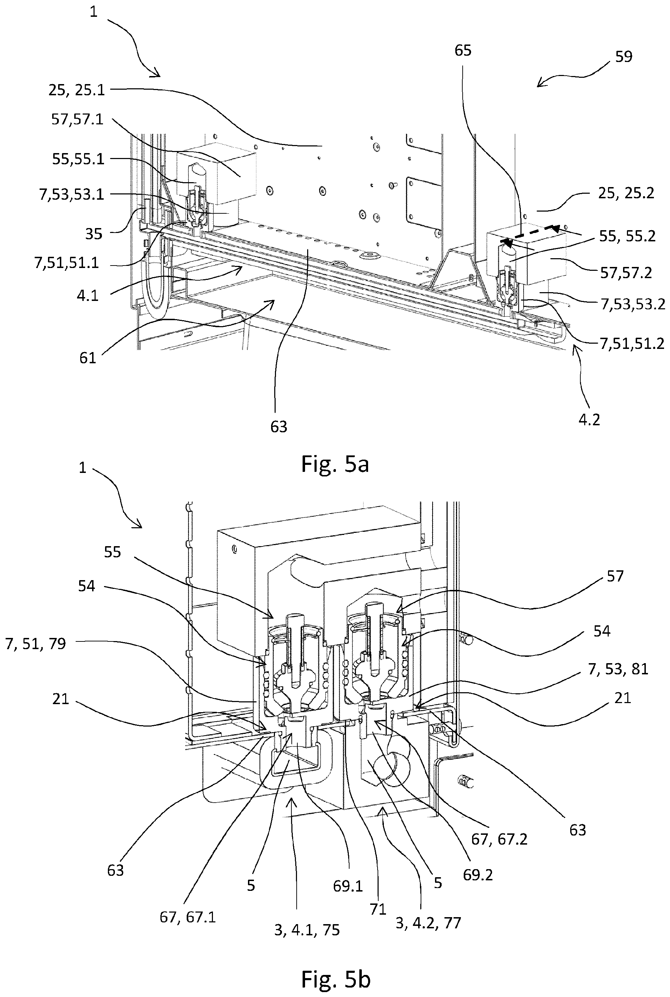

Ein erster Längsschnitt der Ladestation 1, insbesondere der ersten Stelle 47.1 und der zweiten Stelle 47.2, ist in Figur 5a erläutert.

**Figur 5a** zeigt eine schematische, vergrößerte Darstellung einer Längsschnittansicht der Ladestation 1 gemäß Figur 4b

Zu erkennen ist die Fluidzufuhrvorrichtung 4.1 - hier in Längsrichtung geschnitten - und die Fluidabfuhrvorrichtung 4.2.

Die Fluidzufuhrvorrichtung 4.1 weist als die wenigstens zwei ersten Fluidanschlüsse 7 zwei Fluidausgangsanschlüsse 51, nämlich einen ersten Fluidausgangsanschluss 51.1 und einen zweiten Fluidausgangsanschluss 51.2 auf. Der erste Fluidausgangsanschluss 51.1 ist lösbar mit einem ersten Fluidkreislaufeingangsanschluss 55.1, bevorzugt Kühlkreislaufeingangsanschluss, des ersten elektronischen Moduls 25.1, bevorzugt einer Leistungselektronik, verbunden. Der zweite Fluidausgangsanschluss 51.2 ist lösbar mit einem zweiten Fluidkreislaufeingangsanschluss 55.2, bevorzugt Kühlkreislaufeingangsanschluss, des zweiten elektronischen Moduls 25.2, bevorzugt einer Leistungselektronik, verbunden.

Die Fluidabfuhrvorrichtung 4.2 weist als die zwei ersten Fluidanschlüsse 7 zwei Fluideingangsanschlüsse 53, nämlich einen ersten Fluideingangsanschluss 53.1 und einen zweiten Fluideingangsanschluss 53.2 auf. Der erste Fluideingangsanschluss 53.1 ist lösbar mit einem ersten Fluidkreislaufausgangsanschluss 57.1, bevorzugt Kühlkreislaufausgangsanschluss, des ersten elektronischen Moduls 25.1, bevorzugt der Leistungselektronik, verbunden. Die Fluidabfuhrvorrichtung 4.2 weist hier bevorzugt einen nicht dargestellten, verformbaren Längskanal 5 auf. Der zweite Fluideingangsanschluss 53.2 ist lösbar mit einem zweiten Fluidkreislaufausgangsanschluss 57.2, bevorzugt Kühlkreislaufausgangsanschluss, des zweiten elektronischen Moduls 25.2, bevorzugt der Leistungselektronik, verbunden.

Bevorzugt ist vorgesehen, dass die Ladestation 1 einen Elektronikbereich 59 und einen Fluidbereich 61 aufweist. Zwischen dem Elektronikbereich 59 und dem Fluidbereich 61 ist eine Wandung 63 angeordnet. Die zwei elektronischen Module 25, bevorzugt die Leistungselektronik, sind in dem Elektronikbereich 59 angeordnet. Die Fluidzufuhrvorrichtung 4.1 und die Fluidabfuhrvorrichtung 4.2 sind in dem Fluidbereich 61 angeordnet.

Bevorzugt ist vorgesehen, dass die zwei Fluidausgangsanschlüsse 51 und der Klimatisierungsvorrichtungsausgang 35 derart aufeinander abgestimmt sind, dass im Betrieb der Ladestation eine vorbestimmte Aufteilung der jeweils hindurchtretenden Fluidströme erreicht ist, was auch als hydraulischer Abgleich bezeichnet wird.

Ein strichliert dargestellter zweiter Schnitt 65 der Ladestation 1, insbesondere ein Querschnitt der Fluidzufuhrvorrichtung 4.1 und der Fluidabfuhrvorrichtung 4.2, ist in Figur 5b erläutert.

**Figur 5b** zeigt eine schematische, vergrößerte Darstellung einer Schnittansicht eines zweiten Schnitts 65 der Ladestation 1, insbesondere eines Querschnitts der Fluidzufuhrvorrichtung 4.1 und der Fluidabfuhrvorrichtung 4.2, gemäß Figur 5a.

Der Fluidkreislaufeingangsanschluss 55 und der Fluidkreislaufausgangsanschluss 57 weisen jeweils einen Stecker 54 auf.

Der Stecker 54 des Fluidkreislaufeingangsanschlusses 55 ist bevorzugt mit dem Fluidausgangsanschluss 51 strömungstechnisch verbindbar, indem der Stecker 54 des Fluidkreislaufeingangsanschlusses 55 lösbar in den Fluidausgangsanschluss 51 eingesteckt wird.

Der Stecker 54 des Fluidkreislaufausgangsanschlusses 57 ist bevorzugt mit dem Fluideingangsanschluss 53 strömungstechnisch verbindbar, indem der Stecker 54 des Fluidkreislaufausgangsanschlusses 57 lösbar in den Fluideingangsanschluss 53 eingesteckt wird.

Bevorzugt ist vorgesehen, dass die Lagerungsausnehmung 21 einer fixierten Fluidführungsvorrichtung 75 - hier der Fluidzufuhrvorrichtung 4.1 -, ausgewählt aus der Fluidzufuhrvorrichtung 4.1 und der Fluidabfuhrvorrichtung 4.2, mit einem ersten Durchbruch 67.1 der Wandung 63 der Ladestation 1 zusammenwirkt, sodass ein fixierter Fluidanschluss 79 der wenigstens zwei ersten Fluidanschlüsse 7 der fixierten Fluidführungsvorrichtung 75, in der Ladestation 1 befestigt, bevorzugt verlagerungsfrei befestigt, bevorzugt geklemmt, ist. Ein erster Fluidpfad 69.1 ist von dem Längskanal 5 der fixierten Fluidführungsvorrichtung 75 zu dem fixierten Fluidanschluss 79 gebildet, wobei der erste Fluidpfad 69.1 durch den ersten Durchbruch 67.1 hindurchgeführt ist.

Die Lagerungsausnehmung 21 einer verlagerbaren Fluidführungsvorrichtung 77 - hier der Fluidabfuhrvorrichtung 4.2 -, ausgewählt aus der Fluidzufuhrvorrichtung 4.1 und der Fluidabfuhrvorrichtung 4.2, wirkt mit einem zweiten Durchbruch 67.2 der Wandung 63 der Ladestation 1 zusammen, sodass ein verlagerbarer Fluidanschluss 81 der wenigstens zwei ersten Fluidanschlüsse 7 der verlagerbaren Fluidführungsvorrichtung 77, in der Ladestation 1 verlagerbar gelagert ist. Ein zweiter Fluidpfad 69.2 ist von dem Längskanal 5 der verlagerbaren Fluidführungsvorrichtung 77 zu dem verlagerbaren Fluidanschluss 81 gebildet, wobei der zweite Fluidpfad 69.2 durch den zweiten Durchbruch 67.2 hindurchgeführt ist.

Zu erkennen ist ebenfalls, dass der zweite Durchbruch 67.2 gegenüber dem ersten Durchbruch 67.1 einen größeren Durchmesser aufweist. Ob eine Fluidführungsvorrichtung 3 somit fixiert oder verlagerbar in der Ladestation 1 angeordnet ist, ist bevorzugt abhängig von einem Durchmesser des jeweiligen Durchbruchs 67, womit ein Durchmesser der Fluidzufuhrvorrichtung 4.1 und ein Durchmesser der Fluidabfuhrvorrichtung 4.2 gleich gewählt werden können.

Bevorzugt ist vorgesehen, dass zwischen dem verlagerbaren Fluidanschluss 81 der verlagerbaren Fluidführungsvorrichtung 77 und der Wandung 63 ein Gleitelement 71, bevorzugt ein Gleitring, bevorzugt ein Kunststoffring, bevorzugt auf einer geodätisch oberen Seite der Wandung 63, angeordnet ist.

## Patentansprüche

1. Fluidführungsvorrichtung (3) zur Führung eines Fluids in einer Ladestation (1), wobei
- die Fluidführungsvorrichtung (3) einen sich in einer Längsrichtung erstreckenden Längskanal (5) aufweist, wobei
- an dem Längskanal (5) entlang der Längsrichtung wenigstens zwei erste quer zur Längsrichtung abgehende Fluidanschlüsse (7) angeordnet sind, wobei
- an einem ersten Ende (9.1) des Längskanals (5) wenigstens ein zweiter Fluidanschluss (11) angeordnet ist, wobei
- der Längskanal (5) an einem dem ersten Ende (9.1) gegenüberliegenden zweiten Ende (9.2) stirnseitig geschlossen ist, wobei
- der Längskanal (5) die wenigstens zwei ersten Fluidanschlüsse (7) strömungstechnisch parallel mit dem wenigstens einen zweiten Fluidanschluss (11) verbindet, wobei
- der Längskanal (5) verformbar ausgebildet ist, wobei
- der Längskanal (5) und wenigstens ein erster Fluidanschluss (7), ausgewählt aus den wenigstens zwei ersten Fluidanschlüssen (7), eine Lagerungsausnehmung (21) bilden, wobei
- die Lagerungsausnehmung (21) eingerichtet ist, um die Fluidführungsvorrichtung (3) in der Ladestation (1) zu lagern.

2. Fluidführungsvorrichtung (3) nach Anspruch 1, wobei die wenigstens zwei ersten Fluidanschlüsse (7) an dem Längskanal (5) lösbar befestigt sind.

3. Ladestation (1) mit wenigstens einem elektronischen Modul (25) und mit wenigstens zwei Fluidführungsvorrichtungen (3), wobei
- die wenigstens zwei Fluidführungsvorrichtungen (3) jeweils einen sich in einer Längsrichtung erstreckenden Längskanal (5) aufweisen, wobei
- jeweils an dem Längskanal (5) entlang der Längsrichtung wenigstens zwei erste quer zur Längsrichtung abgehende Fluidanschlüsse (7) angeordnet sind, wobei
- jeweils an einem ersten Ende (9.1) des Längskanals (5) wenigstens ein zweiter Fluidanschluss (11) angeordnet ist, wobei
- der Längskanal (5) jeweils an einem dem ersten Ende (9.1) gegenüberliegenden zweiten Ende (9.2) stirnseitig geschlossen ist, wobei
- der Längskanal (5) jeweils die wenigstens zwei ersten Fluidanschlüsse (7) strömungstechnisch parallel mit dem wenigstens einen zweiten Fluidanschluss (11) verbindet, wobei
- die Ladestation (1) eine erste Fluidführungsvorrichtung (3.1) der wenigstens zwei Fluidführungsvorrichtungen (3) als eine Fluidzufuhrvorrichtung (4.1) aufweist, wobei
- die Fluidzufuhrvorrichtung (4.1) als die wenigstens zwei ersten Fluidanschlüsse (7) wenigstens zwei Fluidausgangsanschlüsse (51) aufweist, wobei
- ein Fluidausgangsanschluss (51) der wenigstens zwei Fluidausgangsanschlüsse (51) lösbar mit einem Fluidkreislaufeingangsanschluss (55) des wenigstens einen elektronischen Moduls (25) verbunden ist, wobei
- die Ladestation (1) eine zweite Fluidführungsvorrichtung (3.2) der wenigstens zwei Fluidführungsvorrichtungen (3) als eine Fluidabfuhrvorrichtung (4.2) aufweist, wobei
- die Fluidabfuhrvorrichtung (4.2) als die wenigstens zwei ersten Fluidanschlüsse (7) wenigstens zwei Fluideingangsanschlüsse (53) aufweist, wobei
- ein Fluideingangsanschluss (53) der wenigstens zwei Fluideingangsanschlüsse (53) lösbar mit einem Fluidkreislaufausgangsanschluss (57) des wenigstens einen elektronischen Moduls (25) verbunden ist, wobei
- eine der Fluidführungsvorrichtungen (3), ausgewählt aus der Fluidabfuhrvorrichtung (4.2) und der Fluidzufuhrvorrichtung (4.1), einen verformbaren Längskanal (5) aufweist, wobei der verformbare Längskanal (5) und wenigstens ein erster Fluidanschluss (7), ausgewählt aus den wenigstens zwei ersten Fluidanschlüssen (7), eine Lagerungsausnehmung (21) bilden, wobei die Lagerungsausnehmung (21) eingerichtet ist, um die Fluidführungsvorrichtung (3) in der Ladestation (1) zu lagern.

4. Ladestation (1) nach Anspruch 3, wobei
- zumindest ein Fluidanschluss, ausgewählt aus den wenigstens zwei Fluidausgangsanschlüssen (51) und den wenigstens zwei Fluideingangsanschlüssen (53), eine Steckeraufnahme (8) aufweist, wobei
- ein dem Fluidanschluss zugeordneter Fluidkreislaufanschluss, ausgewählt aus dem Fluidkreislaufeingangsanschluss (55) und dem Fluidkreislaufausgangsanschluss (57), einen Stecker (54) aufweist, wobei
- der Stecker (54) mit der Steckeraufnahme (8) strömungstechnisch verbindbar ist, indem der Stecker (54) lösbar in die Steckeraufnahme (8) eingesteckt wird.

5. Ladestation (1) nach Anspruch 3 oder 4, wobei
- die Lagerungsausnehmung (21) einer fixierten Fluidführungsvorrichtung (75), ausgewählt aus der Fluidzufuhrvorrichtung (4.1) und der Fluidabfuhrvorrichtung (4.2), mit einem ersten Durchbruch (67.1) einer Wandung (63) der Ladestation (1) zusammenwirkt, sodass ein fixierter Fluidanschluss (79) der wenigstens zwei ersten Fluidanschlüsse (7) der fixierten Fluidführungsvorrichtung (75), in der Ladestation (1) befestigt ist, wobei ein erster Fluidpfad (69.1) von dem Längskanal (5) der fixierten Fluidführungsvorrichtung (75) zu dem fixierten Fluidanschluss (79) gebildet ist, wobei der erste Fluidpfad (69.1) durch den ersten Durchbruch (67.1) hindurchgeführt ist, wobei
- die Lagerungsausnehmung (21) einer verlagerbaren Fluidführungsvorrichtung (77), ausgewählt aus der Fluidzufuhrvorrichtung (4.1) und der Fluidabfuhrvorrichtung (4.2), mit einem zweiten Durchbruch (67.2) der Wandung (63) der Ladestation (1) zusammenwirkt, sodass ein verlagerbarer Fluidanschluss (81) der wenigstens zwei ersten Fluidanschlüsse (7) der verlagerbaren Fluidführungsvorrichtung (77), in der Ladestation (1) verlagerbar gelagert ist, wobei ein zweiter Fluidpfad (69.2) von dem Längskanal (5) der verlagerbaren Fluidführungsvorrichtung (77) zu dem verlagerbaren Fluidanschluss (81) gebildet ist, wobei der zweite Fluidpfad (69.2) durch den zweiten Durchbruch (67.2) hindurchgeführt ist.

6. Ladestation (1) nach Anspruch 5, wobei zwischen dem verlagerbaren Fluidanschluss (81) der verlagerbaren Fluidführungsvorrichtung (77) und der Wandung (63) ein Gleitelement (71) angeordnet ist.

7. Ladestation (1) nach Anspruch 5 oder 6, wobei
- die Ladestation (1) einen Elektronikbereich (59) und einen Fluidbereich (61) aufweist, wobei
- zwischen dem Elektronikbereich (59) und dem Fluidbereich (61) die Wandung (63) angeordnet ist, wobei
- das wenigstens eine elektronische Modul (25) in dem Elektronikbereich (59) angeordnet ist, wobei
- die Fluidzufuhrvorrichtung (4.1) und die Fluidabfuhrvorrichtung (4.2) in dem Fluidbereich (61) angeordnet sind.

8. Ladestation (1) nach einem der Ansprüche 5 bis 7, mit einer Wärmespeichervorrichtung (27) und einer Klimatisierungsvorrichtung (29), wobei
- die Fluidzufuhrvorrichtung (4.1) als den wenigstens einen zweiten Fluidanschluss (11) zwei zweite Fluidanschlüsse (11), nämlich einen Wärmespeichervorrichtungseingang (33) als einen ersten zweiten Fluidanschluss (11.1) und einen Klimatisierungsvorrichtungsausgang (35) als einen zweiten zweiten Fluidanschluss (11.2), aufweist, wobei
- der Wärmespeichervorrichtungseingang (33) strömungstechnisch mit der Wärmespeichervorrichtung (27) und der Klimatisierungsvorrichtungsausgang (35) strömungstechnisch mit einem Zulauf der Klimatisierungsvorrichtung (29) verbunden ist, wobei
- die Fluidabfuhrvorrichtung (4.2) als den wenigstens einen zweiten Fluidanschluss (11) zwei zweite Fluidanschlüsse (11), nämlich einen Wärmespeichervorrichtungsausgang (39) als einen ersten zweiten Fluidanschluss (11.1) und einen Klimatisierungsvorrichtungseingang (41) als einen zweiten zweiten Fluidanschluss (11.2), aufweist, wobei
- der Wärmespeichervorrichtungsausgang (39) strömungstechnisch mit der Wärmespeichervorrichtung (27) und der Klimatisierungsvorrichtungseingang (41) strömungstechnisch mit einem Ablauf der Klimatisierungsvorrichtung (29) verbunden ist.

9. Ladestation (1) nach Anspruch 8, wobei die zwei Fluidausgangsanschlüsse (51) und der Klimatisierungsvorrichtungsausgang (35) derart aufeinander abgestimmt sind, dass im Betrieb der Ladestation (1) eine vorbestimmte Aufteilung der jeweils hindurchtretenden Fluidströme erreicht ist.

10. Ladestation (1) nach einem der Ansprüche 3 bis 9, mit einer Fluidfördervorrichtung (31), die eingerichtet ist, um ein Fluid der Ladestation (1) zu fördern.

## Claims

1. A fluid guiding device (3) for guiding a fluid in a charging station (1), wherein
- the fluid guiding device (3) has a longitudinal channel (5) extending in a longitudinal direction, wherein
- at the longitudinal channel (5) along the longitudinal direction at least two first fluid connectors (7) extending transversely to the longitudinal direction are arranged, wherein
- at a first end (9.1) of the longitudinal channel (5) at least one second fluid connector (11) is arranged, wherein
- the longitudinal channel (5) is closed at the end face of a second end (9.2) opposite the first end (9.1), wherein
- the longitudinal channel (5) fluidically connects in parallel the at least two first fluid connectors (7) with the at least one second fluid connector (11), wherein
- the longitudinal channel (5) is configured deformably, wherein
- the longitudinal channel (5) and at least one first fluid connector (7), selected from the at least two first fluid connectors (7), form a bearing recess (21), wherein
- the bearing recess (21) is adapted to mount the fluid guiding device (3) in the charging station (1).

2. The fluid guiding device (3) of claim 1, wherein the at least two first fluid connectors (7) are detachably fastened to the longitudinal channel (5).

3. A charging station (1) having at least one electronic module (25) and having at least two fluid guiding devices (3), wherein
- the at least two fluid guiding devices (3) each have a longitudinal channel (5) extending in a longitudinal direction, wherein
- in each case at the longitudinal channel (5) along the longitudinal direction at least two first fluid connectors (7) extending transversely to the longitudinal direction are arranged, wherein
- in each case at a first end (9.1) of the longitudinal channel (5) at least one second fluid connector (11) is arranged, wherein
- in each case the longitudinal channel (5) is closed at the end face of a second end (9.2) opposite the first end (9.1), wherein
- in each case the longitudinal channel (5) fluidically connects in parallel the at least two first fluid connectors (7) with the at least one second fluid connector (11), wherein
- the charging station (1) has a first fluid guiding device (3.1) of the at least two fluid guiding devices (3) as a fluid supply device (4.1), wherein
- the fluid supply device (4.1) has as the at least two first fluid connectors (7) at least two fluid outlet connectors (51), wherein
- a fluid outlet connector (51) of the at least two fluid outlet connectors (51) is detachably connected to a fluid circuit inlet connector (55) of the at least one electronic module (25), wherein
- the charging station (1) has a second fluid guiding device (3.2) of the at least two fluid guiding devices (3) as a fluid removal device (4.2), wherein
- the fluid removal device (4.2) has as the at least two first fluid connectors (7) at least two fluid inlet connectors (53), wherein
- a fluid inlet connector (53) of the at least two fluid inlet connectors (53) is detachably connected to a fluid circuit outlet connector (57) of the at least one electronic module (25), wherein
- one of the fluid guiding devices (3), selected from the fluid removal device (4.2) and the fluid supply device (4.1), has a deformable longitudinal channel (5), wherein the deformable longitudinal channel (5) and at least one first fluid connector (7), selected from the at least two first fluid connectors (7), form a bearing recess (21), wherein the bearing recess (21) is adapted to mount the fluid guiding device (3) in the charging station (1).

4. The charging station (1) of claim 3, wherein
- at least one fluid connector, selected from the at least two fluid outlet connectors (51) and the at least two fluid inlet connectors (53), has a plug receiver (8), wherein
- a fluid circuit connector assigned to the fluid connector, selected from the fluid circuit inlet connector (55) and the fluid circuit outlet connector (57), has a plug (54), wherein
- the plug (54) is fluidically connectable to the plug receiver (8) by releasably inserting the plug (54) into the plug receiver (8).

5. The charging station (1) of claim 3 or 4, wherein
- the bearing recess (21) of a fixed fluid guiding device (75), selected from the fluid supply device (4.1) and the fluid removal device (4.2), interacts with a first opening (67.1) of a wall (63) of the charging station (1), such that a fixed fluid connector (79) of the at least two first fluid connectors (7) of the fixed fluid guiding device (75) is fastened in the charging station (1), wherein a first fluid path (69. 1) is formed from the longitudinal channel (5) of the fixed fluid guiding device (75) to the fixed fluid connector (79), wherein the first fluid path (69.1) is passed through the first opening (67.1), wherein
- the bearing recess (21) of a displaceable fluid guiding device (77), selected from the fluid supply device (4.1) and the fluid removal device (4.2), interacts with a second opening (67.2) of the wall (63) of the charging station (1), such that a displaceable fluid connector (81) of the at least two first fluid connectors (7) of the displaceable fluid guiding device (77) is displaceably mounted in the charging station (1), wherein a second fluid path (69. 2) is formed from the longitudinal channel (5) of the displaceable fluid guiding device (77) to the displaceable fluid connector (81), wherein the second fluid path (69.2) is passed through the second opening (67.2).

6. The charging station (1) of claim 5, wherein a sliding element (71) is arranged between the displaceable fluid connector (81) of the displaceable fluid guiding device (77) and the wall (63).

7. The charging station (1) of claim 5 or 6, wherein
- the charging station (1) has an electronics area (59) and a fluid area (61), wherein
- between the electronics area (59) and the fluid area (61) the wall (63) is arranged, wherein
- the at least one electronic module (25) is arranged in the electronics area (59), wherein
- the fluid supply device (4.1) and the fluid removal device (4.2) are arranged in the fluid area (61).

8. The charging station (1) of one of claims 5 to 7, having a heat storage device (27) and a climatization device (29), wherein
- the fluid supply device (4.1) has as the at least one second fluid connector (11) two second fluid connectors (11), namely a heat storage device inlet (33) as a first second fluid connector (11.1) and a climatization device outlet (35) as a second second fluid connector (11.2), wherein
- the heat storage device inlet (33) is fluidically connected to the heat storage device (27) and the climatization device outlet (35) is fluidically connected to an inlet of the climatization device (29), wherein
- the fluid removal device (4.2) has as the at least one second fluid connector (11) two second fluid connectors (11), namely a heat storage device outlet (39) as a first second fluid connector (11.1) and a climatization device inlet (41) as a second second fluid connector (11.2), wherein
- the heat storage device outlet (39) is fluidically connected to the heat storage device (27) and the climatization device inlet (41) is fluidically connected to a drain of the climatization device (29).

9. The charging station (1) of claim 8, wherein the two fluid outlet connectors (51) and the climatization device outlet (35) are matched to one another in such a way that, during operation of the charging station (1), a predetermined distribution of each through passing fluid flows is achieved.

10. The charging station (1) of one of claims 3 to 9, having a fluid conveying device (31) which is adapted to convey a fluid of the charging station (1).

## Revendications

1. Dispositif de guidage de fluide (3) destiné à guider un fluide dans une station de charge (1), dans lequel
- le dispositif de guidage de fluide (3) présente un canal longitudinal (5) s'étendant dans un sens longitudinal, dans lequel
- sont disposés sur le canal longitudinal (5) le long du sens longitudinal au moins deux premiers raccords de fluide (7) sortant transversalement au sens longitudinal, dans lequel
- est disposé à une première extrémité (9.1) du canal longitudinal (5) au moins un deuxième raccord de fluide (11), dans lequel
- le canal longitudinal (5) est fermé du côté frontal à une deuxième extrémité (9.2) opposée à la première extrémité (9.1), dans lequel
- le canal longitudinal (5) relie les au moins deux premiers raccords de fluide (7) en termes de technique des fluides parallèlement au au moins un deuxième raccord de fluide (11), dans lequel
- le canal longitudinal (5) est conçu d'une manière déformable, dans lequel
- le canal longitudinal (5) et au moins un premier raccord de fluide (7), sélectionné parmi les au moins deux premiers raccords de fluide (7), forment un évidement de stockage (21), dans lequel
- l'évidement de stockage (21) est configuré pour stocker le dispositif de guidage de fluide (3) dans la station de charge (1).

2. Dispositif de guidage de fluide (3) selon la revendication 1, dans lequel les au moins deux premiers raccords de fluide (7) sont fixés d'une manière détachable sur le canal longitudinal (5).

3. Station de charge (1) avec au moins un module électronique (25) et avec au moins deux dispositifs de guidage de fluide (3), dans laquelle
- les au moins deux dispositifs de guidage de fluide (3) présentent à chaque fois un canal longitudinal (5) s'étendant dans un sens longitudinal, dans laquelle
- sont disposés à chaque fois sur le canal longitudinal (5) le long du sens longitudinal au moins deux premiers raccords de fluide (7) sortant transversalement au sens longitudinal, dans laquelle
- est disposé à chaque fois à une première extrémité (9.1) du canal longitudinal (5) au moins un deuxième raccord de fluide (11), dans laquelle
- le canal longitudinal (5) est fermé du côté frontal à chaque fois à une deuxième extrémité (9.2) opposée à la première extrémité (9.1), dans laquelle
- le canal longitudinal (5) relie à chaque fois les au moins deux premiers raccords de fluide (7) en termes de technique des fluides parallèlement au au moins un deuxième raccord de fluide (11), dans laquelle
- la station de charge (1) présente en tant que dispositif d'alimentation en fluide (4.1) un premier dispositif de guidage de fluide (3.1) des au moins deux dispositifs de guidage de fluide (3), dans laquelle
- le dispositif d'alimentation en fluide (4.1) présente en tant qu'au moins deux premiers raccords de fluide (7) au moins deux raccords de sortie de fluide (51), dans laquelle
- un raccord de sortie de fluide (51) des au moins deux raccords de sortie de fluide (51) est relié d'une manière détachable à un raccord d'entrée de circuit de fluide (55) du au moins un module électronique (25), dans laquelle
- la station de charge (1) présente en tant que dispositif d'évacuation de fluide (4.2) un deuxième dispositif de guidage de fluide (3.2) des au moins deux dispositifs de guidage de fluide (3), dans laquelle
- le dispositif d'évacuation de fluide (4.2) présente en tant qu'au moins deux premiers raccords de fluide (7) au moins deux raccords d'entrée de fluide (53), dans laquelle
- un raccord d'entrée de fluide (53) des au moins deux raccords d'entrée de fluide (53) est relié d'une manière détachable à un raccord de sortie de circuit de fluide (57) du au moins un module électronique (25), dans laquelle
- un des dispositifs de guidage de fluide (3), sélectionné parmi le dispositif d'évacuation de fluide (4.2) et le dispositif d'alimentation en fluide (4.1), présente un canal longitudinal déformable (5), dans laquelle le canal longitudinal déformable (5) et au moins un premier raccord de fluide (7), sélectionné parmi les au moins deux premiers raccords de fluide (7), forment un évidement de stockage (21), dans laquelle l'évidement de stockage (21) est configuré pour stocker le dispositif de guidage de fluide (3) dans la station de charge (1).

4. Station de charge (1) selon la revendication 3, dans laquelle
- au moins un raccord de fluide, sélectionné parmi les au moins deux raccords de sortie de fluide (51) et les au moins deux raccords d'entrée de fluide (53), présente un logement de prise (8), dans laquelle
- un raccord de circuit de fluide affecté au raccord de fluide, sélectionné parmi le raccord d'entrée de circuit de fluide (55) et le raccord de sortie de circuit de fluide (57), présente une prise (54), dans laquelle
- la prise (54) peut être reliée en termes de technique des fluides au logement de prise (8), tandis que la prise (54) est insérée d'une manière détachable dans le logement de prise (8).

5. Station de charge (1) selon la revendication 3 ou 4, dans laquelle
- l'évidement de stockage (21) d'un dispositif de guidage de fluide fixe (75), sélectionné parmi le dispositif d'alimentation en fluide (4.1) et le dispositif d'évacuation de fluide (4.2), interagit avec une première rupture (67.1) d'une paroi (63) de la station de charge (1), de sorte qu'un raccord de fluide fixe (79) des au moins deux premiers raccords de fluide (7) du dispositif de guidage de fluide fixe (75), est fixé dans la station de charge (1), dans laquelle un premier trajet de fluide (69.1) du canal longitudinal (5) du dispositif de guidage de fluide fixe (75) au raccord de fluide fixe (79) est formé, dans laquelle le premier trajet de fluide (69.1) est guidé à travers la première rupture (67.1), dans laquelle
- l'évidement de stockage (21) d'un dispositif de guidage de fluide (77) pouvant être stocké, sélectionné parmi le dispositif d'alimentation en fluide (4.1) et le dispositif d'évacuation de fluide (4.2), interagit avec une deuxième rupture (67.2) de la paroi (63) de la station de charge (1), de sorte qu'un raccord de fluide (81) pouvant être stocké des au moins deux premiers raccords de fluide (7) du dispositif de guidage de fluide (77) pouvant être stocké, est logé d'une manière à pouvoir être stocké dans la station de charge (1), dans laquelle est formé un deuxième trajet de fluide (69.2) du canal longitudinal (5) du dispositif de guidage de fluide (77) pouvant être stocké au raccord de fluide (81) pouvant être stocké, dans laquelle le deuxième trajet de fluide (69.2) est guidé à travers la deuxième rupture (67.2).

6. Station de charge (1) selon la revendication 5, dans laquelle est disposé un élément coulissant (71) entre le raccord de fluide (81) pouvant être stocké du dispositif de guidage de fluide (77) pouvant être stocké et la paroi (63).

7. Station de charge (1) selon la revendication 5 ou 6, dans laquelle
- la station de charge (1) présente une zone électronique (59) et une zone fluide (61), dans laquelle
- entre la zone électronique (59) et la zone fluide (61) est disposée la paroi (63), dans laquelle
- le au moins un module électronique (25) est disposé dans la zone électronique (59), dans laquelle
- le dispositif d'alimentation en fluide (4.1) et le dispositif d'évacuation de fluide (4.2) sont disposés dans la zone fluide (61).

8. Station de charge (1) selon l'une des revendications 5 à 7, avec un dispositif accumulateur de chaleur (27) et un dispositif de climatisation (29), dans laquelle
- le dispositif d'alimentation en fluide (4.1) présente deux deuxièmes raccords de fluide (11) en tant que le au moins un deuxième raccord de fluide (11), à savoir une entrée de dispositif accumulateur de chaleur (33) en tant que premier deuxième raccord de fluide (11.1) et une sortie de dispositif de climatisation (35) en tant que second deuxième raccord de fluide (11.2), dans laquelle
- l'entrée du dispositif accumulateur de chaleur (33) est reliée en termes de technique des fluides au dispositif accumulateur de chaleur (27) et la sortie du dispositif de climatisation (35) en termes de technique des fluides à une entrée du dispositif de climatisation (29), dans laquelle
- le dispositif d'évacuation de fluide (4.2) présente deux deuxièmes raccords de fluide (11) en tant que le au moins un deuxième raccord de fluide (11), à savoir une entrée de dispositif accumulateur de chaleur (39) en tant que premier deuxième raccord de fluide (11.1) et une sortie de dispositif de climatisation (41) en tant que second deuxième raccord de fluide (11.2), dans laquelle
- la sortie du dispositif accumulateur de chaleur (39) est reliée en termes de technique des fluides au dispositif accumulateur de chaleur (27) et l'entrée du dispositif de climatisation (41) est reliée en termes de technique des fluides à une décharge du dispositif de climatisation (29).

9. Station de charge (1) selon la revendication 8, dans laquelle les deux raccords de sortie de fluide (51) et la sortie du dispositif de climatisation (35) sont coordonnés d'une manière telle que lors du fonctionnement de la station de charge (1), une répartition prédéterminée des courants de fluide traversant respectifs est obtenue.

10. Station de charge (1) selon l'une des revendications 3 à 9, avec un dispositif de transport de fluide (31) qui est configuré pour transporter un fluide de la station de charge (1).
